# EUROPEAN PATENT APPLICATION

(11) **EP 3 128 638 A1**
(43) Date of publication of application: **08.02.2017**
(21) Application number: 15756808.0
(22) Date of filing: 03.03.2015
(51) Int. Cl.: H02J 3/32, H02J 3/38, H02J 7/35

(54) **MONITORING DEVICE, CONTROL DEVICE AND CONTROL SYSTEM**

(30) Priority: 01.04.2014 JP 2014075594
(71) Applicant: Kabushiki Kaisha Toshiba, Minato-ku Tokyo 105-8001 (JP)
(72) Inventor: WADA, Takahisa, Tokyo 105-8001 (JP); KUBOTA, Masayuki, Tokyo 105-8001 (JP); MIZUTANI, Mami, Tokyo 105-8001 (JP); KUBOTA, Kazuto, Tokyo 105-8001 (JP)
(74) Representative: Awapatent AB
(86) International application number: PCT/JP2015/056240
(87) International publication number: WO 2015/151696

(57) **Abstract**

According to one embodiment, a monitoring apparatus comprises a use history accumulating section, a demand prediction generating section, a power generation predicting section, a deterioration table determining section, a charge and discharge schedule creating section, and a transmission section. A use history accumulating section receives at least battery condition information from a control apparatus that controls a power generating apparatus and a battery and to generate and to store a use history of the battery. A demand prediction generating section generates a demand prediction for power consumed by a power consuming section for which power supply is controlled by the control apparatus. A power generation predicting section configured to generate a power generation prediction for the power generating apparatus. A deterioration table determining section configured to determine a deterioration table indicative of a deterioration rate of the battery based on the use history. A charge and discharge schedule creating section configured to create a charge and discharge schedule for the battery based on the deterioration table, the demand prediction, and the power generation prediction. A transmission section configured to transmit the demand prediction, the power generation prediction, the charge and discharge schedule, and the deterioration table allowing charge and discharge of the battery to be controlled.

## Description

### [Technical Field]

Embodiments of the present invention relate to a monitoring apparatus, a control apparatus, and a control system.

### [Background Art]

A deterioration amount control apparatus that controls an amount of degradation of a battery (battery consumption) receives a charge and discharge schedule from a deterioration amount monitoring apparatus that is a higher apparatus and charges and discharges the battery in accordance with the received charge and discharge schedule. However, the deterioration amount control apparatus is conventionally disadvantageous due to its inability to appropriately control charge and discharge of the battery; for example, if a demand prediction on which the charge and discharge schedule is based is different from actuality, the deterioration amount cannot be appropriately controlled when the charge and discharge are performed in accordance with the charge and discharge schedule.

### [Prior Art Documents]

### [Patent Documents]

[Patent Document 1] Jpn. Pat. Appln. KOKAI Publication No. H08-140205
[Patent Document 2] Jpn. Pat. Appln. KOKAI Publication No. 2004-222427
[Patent Document 3] Jpn. Pat. Appln. KOKAI Publication No. 2012-60833

### [Summary of Invention]

### [Problem To Be Solved by the Invention]

To solve the above-described problem, a monitoring apparatus, a control apparatus, and a control system are provided which allow charge and discharge of a battery to be effectively controlled.

### [Means for Solving the Problem]

According to one embodiment, a monitoring apparatus comprises a use history accumulating section, a demand prediction generating section, a power generation predicting section, a deterioration table determining section, a charge and discharge schedule creating section, and a transmission section. A use history accumulating section receives at least battery condition information from a control apparatus that controls a power generating apparatus and a battery and to generate and to store a use history of the battery. A demand prediction generating section generates a demand prediction for power consumed by a power consuming section for which power supply is controlled by the control apparatus. A power generation predicting section configured to generate a power generation prediction for the power generating apparatus. A deterioration table determining section configured to determine a deterioration table indicative of a deterioration rate of the battery based on the use history. A charge and discharge schedule creating section configured to create a charge and discharge schedule for the battery based on the deterioration table, the demand prediction, and the power generation prediction. A transmission section configured to transmit the demand prediction, the power generation prediction, the charge and discharge schedule, and the deterioration table allowing charge and discharge of the battery to be controlled.

### [Brief Description of Drawings]

[FIG. 1] FIG. 1 is a block diagram depicting a function example of a deterioration amount control system according to a first embodiment.
[FIG. 2] FIG. 2 is a diagram depicting an example of a deterioration table selected by a deterioration table determining section.
[FIG. 3] FIG. 3 is a diagram depicting an example of a charge and discharge schedule created by a charge and discharge schedule creating section.
[FIG. 4] FIG. 4 is a block diagram depicting a configuration example of a deterioration amount monitoring apparatus according to the first embodiment.
[FIG. 5] FIG. 5 is a block diagram depicting a configuration example of a deterioration amount control apparatus according to the first embodiment.
[FIG. 6] FIG. 6 is a diagram depicting a configuration example of a battery.
[FIG. 7] FIG. 7 is a flowchart illustrating an operation example of the deterioration amount monitoring apparatus according to the first embodiment.
[FIG. 8] FIG. 8 is a flowchart illustrating an operation example of the deterioration amount control apparatus according to the first embodiment.
[FIG. 9] FIG. 9 is a block diagram depicting a function example of a deterioration amount control system according to a second embodiment.
[FIG. 10] FIG. 10 is a flowchart illustrating an operation example of a deterioration amount monitoring apparatus according to the second embodiment.
[FIG. 11] FIG. 11 is a flowchart illustrating an operation example of a deterioration amount control apparatus according to the second embodiment.
[FIG. 12] FIG. 12 is a block diagram depicting a function example of a deterioration amount control system according to a third embodiment.
[FIG. 13] FIG. 13 is a flowchart illustrating an operation example of a deterioration amount control apparatus according to the third embodiment.
[FIG. 14] FIG. 14 is a flowchart illustrating an operation example of a deterioration amount monitoring apparatus according to the third embodiment.
[FIG. 15] FIG. 15 is a flowchart illustrating an operation example of the deterioration amount control apparatus according to the third embodiment.

### [Mode for Carrying Out the Invention]

### (First Embodiment)

A first embodiment will be described below with reference to the drawings.

A deterioration amount control system according to a first embodiment controls a deterioration amount of a battery (or battery consumption). A deterioration amount monitoring apparatus generates a charge and discharge schedule for the battery based on information on the battery transmitted by the deterioration amount control apparatus. The deterioration amount control apparatus controls charge and discharge of the battery in accordance with, for example, the charge and discharge schedule generated by the deterioration amount monitoring apparatus. Furthermore, the battery comprises a plurality of battery cells.

Additionally, the deterioration amount control apparatus controls power supplied to personal residences or power consuming sections of factories and the like. That is, the deterioration amount control system supplies power to the power consuming sections from batteries or through transmission lines.

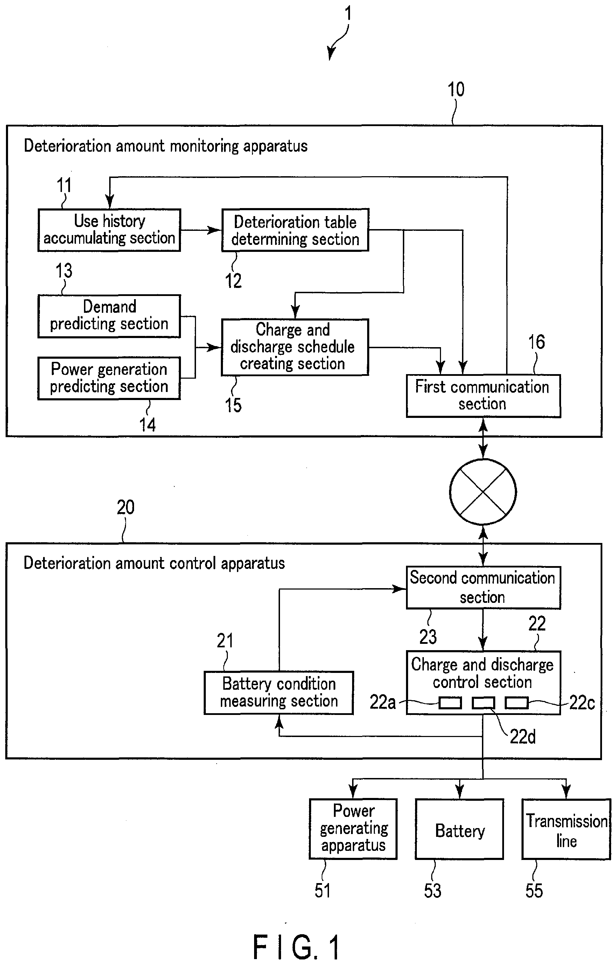

FIG. 1 is a block diagram depicting a function example of deterioration amount control system 1 (control system) comprising a deterioration amount monitoring apparatus 10 (monitoring apparatus) and a deterioration amount control apparatus 20 (control apparatus).

As depicted in FIG. 1, the deterioration amount monitoring apparatus 10 comprises a use history accumulating section 11, a deterioration table determining section 12, a demand predicting section 13, a power generation predicting section 14, a charge and discharge schedule creating section 15, and a first communication section 16.

The use history accumulating section 11 stores a use history of a battery 53 controlled by the deterioration amount control system 1. The use history is information indicating that battery conditions such as the temperature, SOC (State of Charge), current, voltage, and internal resistance, and capacity of the battery 53 have changed over time. The information stored in the use history is not limited to a particular configuration.

The use history accumulating section 11 generates a use history based on battery condition information generated and transmitted by the deterioration amount control apparatus 20. The deterioration amount control apparatus 20 transmits the battery condition information including the temperature, SOC, current, voltage, and internal resistance, and capacity of the battery 53, to the deterioration amount monitoring apparatus 10 as needed. Furthermore, the deterioration amount control apparatus 20 may transmit the battery condition information at predetermined intervals. Each time the deterioration amount control apparatus 20 transmits the battery condition information, the use history accumulating section 11 stores the transmitted battery condition information in accordance with a time series as a use history.

The deterioration table determining section 12 determines a deterioration table based on the use history stored in the use history accumulating section 11. The deterioration table stores a value indicative of a deterioration rate corresponding to the condition of the battery 53. For example, the deterioration table is indicative of the deterioration rate corresponding to the SOC and the temperature.

For example, the deterioration table determining section 12 pre-stores a plurality of deterioration tables corresponding to the type of the battery 53, the year and month of use, the number of charges and discharges, the current electric current, voltage, internal resistance, and capacity and, like. The deterioration table determining section 12 selects a deterioration table based on the condition of the battery 53.

The deterioration table determining section 12 selects a deterioration table based on the type of the battery 53, the year and month of use, the number of charges and discharges, the current electric current, voltage, internal resistance, and capacity and, like. Parameters used by the deterioration table determining section 12 to generate the deterioration table may be information contained in the use history or information pre-input by an operator or the like. Parameters used by the deterioration table determining section 12 to generate a deterioration table are not limited to a particular configuration.

The deterioration table determining section 12 may generate a deterioration table through learning based on the use history of the battery 53 stored in the use history accumulating section 11. A method in which the deterioration table determining section 12 determines a deterioration table is not limited to a particular method.

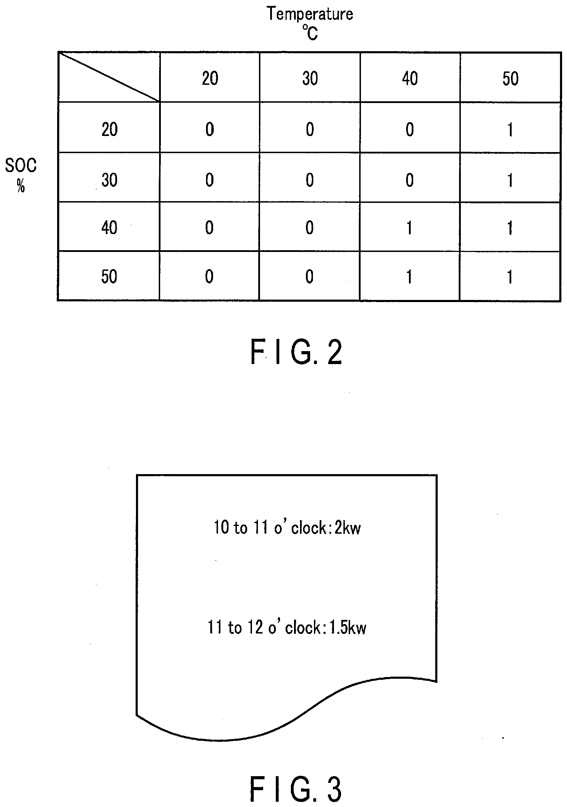

FIG. 2 depicts an example of the deterioration table determined by the deterioration table determining section 12.

As depicted in FIG. 2, the deterioration table is a table that represents the SOC on an axis of ordinate, while representing the temperature on the axis of abscissas. The SOC is indicative of the rate of electric charge stored in the battery 53. For example, an SOC of 50% indicates that 50% of an allowable amount of electric charge is stored in the battery 53. Furthermore, the temperature is the temperature of the battery 53.

In the example depicted in FIG. 2, the deterioration rate is "1" or "0". A deterioration rate of "1" is indicative of a high deterioration rate of the battery 53. Furthermore, a deterioration rate of "0" is indicative of a low deterioration rate of the battery 53.

For example, the deterioration table depicted in FIG. 2 indicates that the battery 53 has a deterioration rate of "0" when the SOC and the temperature are "30%" and "40°C", respectively. That is, the deterioration table indicates that the battery 53 has a low deterioration rate under the conditions. The deterioration table may store values other than the binary value of "0" or "1". For example, the deterioration table may have an intermediate value such as "0.5". That is, the deterioration table may indicate a deterioration rate other than the high or low deterioration rate. The deterioration rate indicated by the deterioration table is not limited to a particular configuration.

The deterioration table determining section 12 transmits the determined deterioration table to the charge and discharge schedule creating section 15.

The demand predicting section 13 generates data indicative of a predicted demand of power consumed by a power consuming section to which the deterioration amount control apparatus 20 supplies power (the data is hereinafter simply referred to as the demand prediction). For example, the demand predicting section 13 may generate a demand prediction using a past demand (for example, the demand of week earlier). In this case, the demand predicting section 13 pre-stores past power demands of the power consuming section. The deterioration amount control apparatus 20 may periodically transmit information indicative of power consumed by the power consuming section, to the deterioration amount monitoring apparatus 10. A method by which the demand predicting section 13 generates a demand prediction for the power consuming section is not limited to a particular method.

The demand predicting section 13 generates a demand prediction for a period needed for the charge and discharge schedule creating section 15 to generate a charge and discharge schedule. For example, when the charge and discharge schedule creating section 15 creates a charge and discharge schedule for a day, the demand predicting section 13 generates a demand prediction for the day.

The demand predicting section 13 transmits the generated demand prediction to the charge and discharge schedule creating section 15.

The power generation predicting section 14 generates a power generation prediction for power generated by a power generating apparatus 51 controlled by the deterioration amount control apparatus 20. For example, the power generation predicting section 14 generates a power generation prediction based on past amounts of power generated by the power generating apparatus 51. When the power generating apparatus 51 is a solar panel, for example, the power generation predicting section 14 generates data on the amount of generated power predicted based on a relation between the past weather and the amount of generated power and a weather forecast for a period for which the amount of generated power is predicted (the data is hereinafter referred to as the power generation prediction).

Furthermore, the power generation predicting section 14 may generate a power generation prediction based on past amounts of power generated by the power generating apparatus 51, measured by the deterioration amount control apparatus 20. In this case, the deterioration amount control apparatus 20 periodically transmits information indicative of power generated by the power generating apparatus 51 to the deterioration amount monitoring apparatus 10.

The power generation predicting section 14 generates a power generation prediction for a period needed for the charge and discharge schedule creating section 15 to generate a charge and discharge schedule. For example, when the charge and discharge schedule creating section 15 creates a charge and discharge schedule for a day, the power generation predicting section 14 generates a demand prediction for the day.

The power generation predicting section 14 transmits the generated power generation prediction to the charge and discharge schedule creating section 15.

The charge and discharge schedule creating section 15 creates schedule data for charge and discharge based on the deterioration table determined by the deterioration table determining section 12, the demand prediction transmitted by the demand predicting section 13, and the power generation prediction transmitted by the power generation predicting section 14 (the schedule data is hereinafter simply referred to as the charge and discharge schedule). The charge and discharge schedule creating section 15 creates a charge and discharge schedule corresponding to a predetermined period (schedule period). The charge and discharge schedule is, For example, a charge and discharge schedule for the battery 53 in accordance with the time series.

The charge and discharge schedule creating section 15 creates a schedule so as to optimize the deterioration amount of the battery 53 and an electricity cost. For example, the charge and discharge schedule creating section 15 temporarily determines a discharge pattern, and uses a heuristic method to discover a discharge pattern that optimizes the deterioration amount and the electricity cost. That is, the charge and discharge schedule creating section 15 calculates the deterioration amount resulting from a certain discharge pattern. The deterioration amount is a value resulting from integration, over time, of the deterioration rate based on the deterioration table. Furthermore, the charge and discharge schedule creating section 15 calculates utility costs resulting from the discharge pattern. The charge and discharge schedule creating section 15 calculates the deterioration amount and the utility costs while varying the discharge pattern, to discover a discharge pattern with the optimum deterioration amount and utility costs.

The charge and discharge schedule creating section 15 may create a discharge schedule that speeds up or suppresses the deterioration of the battery 53. The content and purpose of the discharge schedule created by the charge and discharge schedule creating section 15 is not limited to a particular configuration.

FIG. 3 is an example of the charge and discharge schedule created by the charge and discharge schedule creating section 15.

As depicted in FIG. 3, the charge and discharge schedule stores the amount of electric charge released from the battery 53 and the time in association with each other. For example, the charge and discharge schedule depicted in FIG. 3 indicates that the amount of electric charge released from the battery 53 is 2 kw between 10 and 11 o'clock. Furthermore, the charge and discharge schedule depicted in FIG. 3 indicates that the amount of electric charge released from the battery 53 is 1.5 kw between 11 and 12 o'clock. The charge and discharge schedule indicates the discharge amount corresponding to the schedule period.

The charge and discharge schedule may be a schedule for every hour as depicted in FIG. 3 or a schedule for another period. The charge and discharge schedule may indicate the amount of electric charge supplied through a transmission line 55 or from the power generating apparatus 51. The contents of the charge and discharge schedule are not limited to a particular configuration.

The first communication section 16 transmits, to the deterioration amount control apparatus 20, the demand prediction generated by the demand predicting section 13, the power generation prediction generated by the power generation predicting section 14, the deterioration table determined by the deterioration table determining section 12, and the charge and discharge schedule created by the charge and discharge schedule creating section 15. Furthermore, the first communication section 16 receives the use history transmitted by the deterioration amount control apparatus 20. The first communication section 16 transmits and receives data to and from the deterioration amount control apparatus 20 through the Internet. Additionally, the first communication section 16 may transmit and receive data to and from the deterioration amount control apparatus 20 by wire or wirelessly through another communication network.

Now, the deterioration amount control apparatus 20 will be described.

As depicted in FIG. 1, the deterioration amount control apparatus 20 comprises a battery condition measuring section 21, a charge and discharge control section 22, and a second communication section 23.

The battery condition measuring section 21 measures the condition of the battery. The battery condition measuring section 21 measures, for example, the temperature, SOC, current, voltage, capacity, and internal resistance of the battery. The battery condition measuring section 21 may be, for example, a control board that controls and monitors the battery cells included in the battery. The battery condition measuring section 21 generates battery condition information storing the condition of the battery such as the measured temperature, SOC, current, voltage, capacity, and internal resistance.

The charge and discharge control section 22 has a function to transmit power generated by the power generating apparatus 51 to the power consuming section, a function to transmit power transmitted through the transmission line 55 to the power consuming section, a function to store power generated by the power generating apparatus 51 in the battery 53, a function to store power transmitted through the transmission line 55 in the battery 53, and a function to discharge power from the battery 53 to the power consuming section.

The charge and discharge control section 22 discharges power from the battery 53 to the power consuming section in accordance with the charge and discharge schedule transmitted by the deterioration amount monitoring apparatus 10.

Furthermore, the charge and discharge control section 22 comprises a determination section 22a that determines whether the amount of power generated by the power generating apparatus 51 and the amount of power consumed by the power consuming section are equal to the power generation prediction and the demand prediction, respectively. For example, the determination section 22a determines whether the amount of generated power and the amount of consumed power deviate from the power generation prediction and the demand prediction by predetermined values or larger, respectively.

Furthermore, the charge and discharge schedule 22 comprises a first control section 22b that controls the charge and discharge of the battery 53 in accordance with the charge and discharge schedule. Additionally, the charge and discharge control section 22 comprises a second control section 22c that creates an independent schedule based on the deterioration table to control the charge and discharge of the battery 53 in accordance with the created schedule.

When the determination section 22a determines that the amount of generated power and the amount of consumed power are equal to the power generation prediction and the demand prediction, respectively, the first control section 22b controls the charge and discharge of the battery 53 in accordance with the received charge and discharge schedule.

When the determination section 22a determines that the amount of generated power and the amount of consumed power are not equal to the power generation prediction and the demand prediction, respectively, the second control section 22c creates an independent schedule based on the deterioration table to control the charge and discharge of the battery 53 in accordance with the created independent schedule. For example, when the amount of consumed power is larger than the demand prediction, the second control section 22c determines whether to allow the battery 53 to discharge an amount of power exceeding the demand prediction or utilize the power transmitted through the transmission line 55. In this case, the second control section 22c calculates a deterioration amount resulting from the discharge of the battery 53 based on the deterioration table. Furthermore, the second control section 22c calculates the electricity cost resulting from the utilization of the power transmitted through the transmission line 55. The second control section 22c determines whether to discharge the battery 53 or to utilize the power transmitted through the transmission line 55 based on the deterioration amount and the electricity cost. The second control section 22c may allow the battery 53 to discharge the excess amount of power and utilize the power transmitted through the transmission line 55.

The independent schedule created by the second control section 22c is not limited to a particular configuration.

The second communication section 23 receives the demand prediction, the power generation prediction, the deterioration table, and the charge and discharge schedule transmitted by the deterioration amount monitoring apparatus 10. Furthermore, the second communication section 23 transmits the battery condition information generated by the battery condition measuring section 21 to the deterioration amount monitoring apparatus 10. The second communication section 23 transmits and receives data to and from the deterioration amount monitoring apparatus 10 through the communication network to which the first communication section 16 is connected.

Now, a configuration example of the deterioration amount monitoring apparatus 10 will be described below.

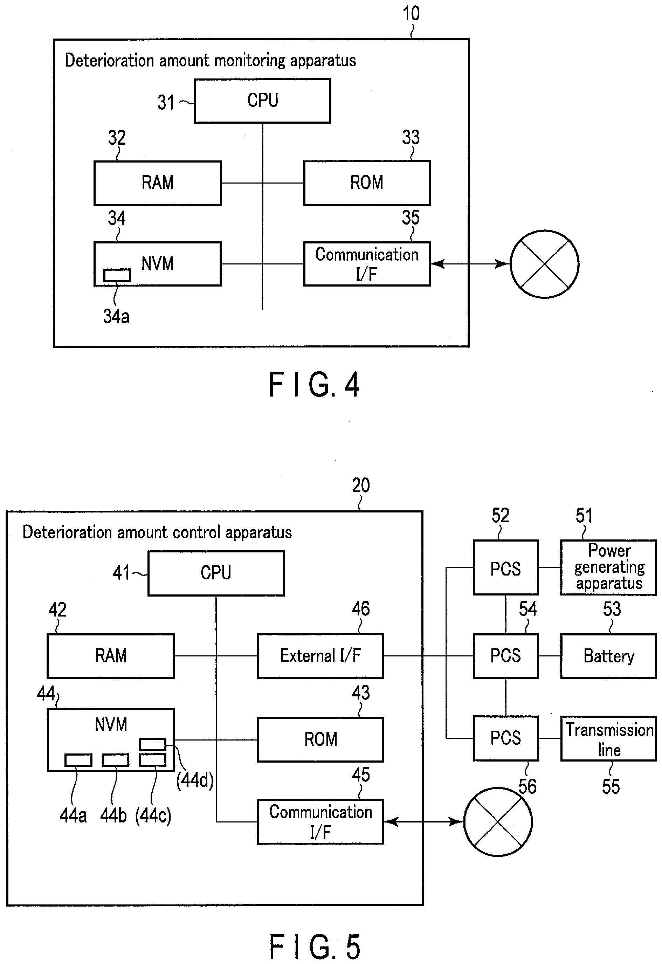

FIG. 4 is a block diagram illustrating a configuration example of the deterioration amount monitoring apparatus 10.

The deterioration amount monitoring apparatus 10 is, for example, a server or a PC. The deterioration amount monitoring apparatus 10 is not limited to particular equipment.

As depicted in FIG. 4, the deterioration amount monitoring apparatus 10 comprises a CPU 31, a RAM 32, a ROM 33, an NVM 34, and a communication interface (I/F) 35.

The CPU 31 controls operations of the whole deterioration amount monitoring apparatus 10. The CPU 31 may comprise internal caches and various interfaces. The CPU 31 executes programs stored in an internal memory, the ROM 33, or the NVM 34 to process various processes. For example, the CPU 31 executes programs to process data input via the communication interface 35. The CPU 31 executes programs to implement functions of the deterioration amount monitoring apparatus 10. Some of the functions implemented by the CPU 31 executing the programs may be functions implemented by a hardware circuit. In this case, the CPU 31 controls the functions implemented by the hardware circuit.

The CPU 31 is an example of a processor.

The RAM 32 is a volatile memory. The RAM 32 temporarily stores, for example, data being processed by the CPU 31. The RAM 32 stores various programs based on instructions from the CPU 31. Furthermore, the RAM 32 may store data needed to execute the programs, results of execution of the programs, and the like.

The ROM 33 is a nonvolatile memory in which controlling programs and control data are pre-stored. The controlling programs and the control data stored in the ROM 33 are pre-embedded according to specifications for the deterioration amount monitoring apparatus 10. The ROM 33 stores, for example, a program that controls a circuit board of the deterioration amount monitoring apparatus 10 (for example, a BIOS).

The NVM 34 is a nonvolatile memory to which data can be written and in which data can be rewritten. The NVM 34 is, For example, a hard disk, an SSD, an EEPROM, or a flash memory. The NVM 34 stores controlling programs, application programs, and various data according to an operational application of the deterioration amount monitoring apparatus 10.

The NVM 34 comprises a recording area 34a in which the use history of the battery 53 is stored.

The communication interface (communication I/F) 35 is an interface that allows data communication with the deterioration amount control apparatus 20.

The deterioration amount monitoring apparatus 10 may further comprise a display section, an operation section, and an external interface. Furthermore, the deterioration amount monitoring apparatus 10 may include additional components other than the above-described components.

Now, a configuration example of the deterioration amount control apparatus 20 will be described.

FIG. 5 is a block diagram illustrating a configuration example of the deterioration amount control apparatus 20.

The deterioration amount control apparatus 20 is, for example, a PC.

As depicted in FIG. 5, the deterioration amount control apparatus 20 comprises a CPU 41, a RAM 42, a ROM 43, an NVM 34, and a communication interface (I/F) 45.

The CPU 41 controls operations of the whole deterioration amount control apparatus 20. The CPU 41 may comprise internal caches and various interfaces. The CPU 41 executes programs stored in an internal memory, the ROM 43, or the NVM 44 to process various processes. For example, the CPU 41 executes programs to process, for example, data input via the communication interface 45. The CPU 41 executes programs to implement functions of the deterioration amount control apparatus 20. Some of the functions implemented by the CPU 31 executing the programs may be functions implemented by a hardware circuit. In this case, the CPU 41 controls the functions implemented by the hardware circuit.

The CPU 41 is an example of a processor.

The RAM 42 is a volatile memory. The RAM 42 temporarily stores, for example, data being processed by the CPU 41. The RAM 42 stores various programs based on instructions from the CPU 41. Furthermore, the RAM 42 may store data needed to execute the programs, results of execution of the programs, and the like.

The ROM 43 is a nonvolatile memory in which controlling programs and control data are pre-stored. The controlling programs and the control data stored in the ROM 43 are pre-embedded according to specifications for the deterioration amount control apparatus 20. The ROM 43 stores, for example, a program that controls a circuit board of the deterioration amount control apparatus 20 (for example, a BIOS).

The NVM 44 is a nonvolatile memory to which data can be written and in which data can be rewritten. The NVM 44 is, For example, a hard disk, an SSD, an EEPROM, or a flash memory. The NVM 44 stores controlling programs, application programs, and various data according to an operational application of the deterioration amount control apparatus 20.

The NVM 44 comprises a recording area 44a in which the deterioration table is stored and a recording area 44b in which the charge and discharge schedule is stored.

The communication interface (communication I/F) 45 is an interface that allows data communication with the deterioration amount monitoring apparatus 10.

The external interface (communication I/F) 46 is an interface that allows control signals to be transmitted to PCSs 52, 54, and 56. The CPU 41 controls the charge and discharge of the battery 53 through an external interface 46.

The deterioration amount control apparatus 20 may further comprise a display section, an operation section, and an external interface. Furthermore, the deterioration amount control apparatus 20 may include additional components other than the above-described components.

The deterioration amount control apparatus 20 connects to the PCSs 52, 54, and 56 through the external interface 46. Furthermore, the PCS 52 connects to the power generating apparatus 51. The PCS 54 connects to the battery 53. Additionally, the PCS 56 connects to the transmission line 55. In addition, the PCS 54 connects to the PCSs 52 and 56.

The power generating apparatus 51 generates power to be stored in the battery 53 or power supplied to the power consuming section. The power generating apparatus 51 supplies the generated power to the PCS 52. For example, the power generating apparatus 51 is a solar panel.

The PCS (power conditioner) 52 controls the power generated by the power generating apparatus 51 based on the control signal from the deterioration amount control apparatus 20. That is, the PCS 52 supplies the power generated by the power generating apparatus 51 to the power consuming section based on the control signal. Furthermore, the PCS 52 stores the power generated by the power generating apparatus 51 in the battery 53 through the PCS 54 based on the control signal.

The battery 53 is a secondary battery comprising a plurality of battery cells. Based on the control of the PCS 54, the battery 53 discharges power or stores the power from the power generating apparatus 51 or through the transmission line 55. The structure of the battery 53 will be described below.

The PCS 54 controls the battery 53 based on the control signal from the deterioration amount control apparatus 20. That is, the PCS 54 extracts power from the battery 53 and supplies the power to the power consuming section based on the control signal. Furthermore, the PCS 54 stores the power supplied from the power generating apparatus 51 or through the transmission line 55, in the battery 53 based on the control signal.

The transmission line 55 transmits power provided by an electric power utility. The power transmitted through the transmission line 55 is supplied to the PCS 56.

The PCS 56 controls the power transmitted through the transmission line 55 based on the control signal from the deterioration amount control apparatus 20. That is, the PCS 56 supplies the power transmitted through the transmission line 55 to the power consuming section based on the control signal. Furthermore, the PCS 56 stores the transmitted power in the battery 53 through the PCS 54 based on the control signal.

Now, a configuration example of the battery 53 will be described.

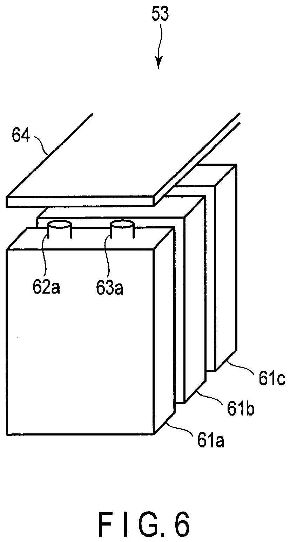

FIG. 6 is a diagram illustrating the configuration example of the battery 53.

As depicted in FIG. 6, the battery 53 comprises battery cells 61a to 61c and a control board 64.

The battery cell 61a is, for example, a non-hydrogen secondary battery such as a lithium ion battery. The battery cell 61a comprises an outer container formed of aluminum or the like and shaped like a flat rectangular box and an electrode member housed in the outer container along with a non-aqueous electrolyte. The electrode member is shaped into a flat rectangle by, for example, spirally rolling a positive electrode plate and a negative electrode plate with separators interposed between the positive electrode plate and a negative electrode plate and compressing the plates in a radial direction.

A positive electrode terminal 62a and a negative electrode terminal 63a are installed at longitudinally opposite ends of the outer casing and protruding outward from the outer container. The positive electrode terminal 62a and a negative electrode terminal 63a are connected to a positive pole and a negative pole, respectively, of the electrode member.

The battery cells 61b and 61c are configured similarly to the battery cell 61a. The configuration and number of the battery cells included in the battery 53 are not limited to a particular configuration.

The control board 64 is configured using a rectangular control circuit board. The control board 64 covers most of the battery cells 61. The control board 64 is fixed to, for example, a ceiling wall of the outer container of the battery 53.

The control board 64 is electrically connected to each of the battery cells 61. The control board 64 detects the voltage, current, temperature, and the like of each of the battery cells 61 and performs various control operations so as to allow the battery 53 to operate properly.

Now, an operation example of the deterioration amount monitoring apparatus 10 will be described.

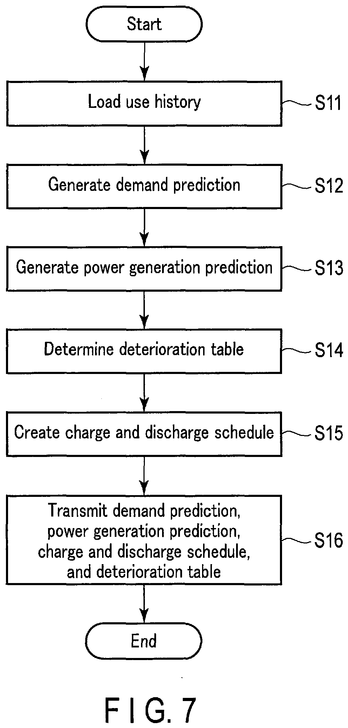

FIG. 7 is a flowchart illustrating an operation example of the deterioration amount monitoring apparatus 10.

In this regard, the use history accumulating section 11 of the deterioration amount monitoring apparatus 10 is assumed to store the previous use history of the battery 53.

First, the deterioration table determining section 12 of the deterioration amount monitoring apparatus 10 loads the use history from the use history accumulating section 11 (step S11). When the deterioration table determining section 12 loads the use history, the demand predicting section 13 generates a demand prediction for the power consuming section (step S12).

When the demand predicting section 13 generates a demand prediction, the power generation predicting section 14 generates a power generation prediction for the power generating apparatus 51 (step S13). When the power generation predicting section 14 generates the power generation prediction, the deterioration table determining section 12 determines a deterioration table based on the use history (step S14).

When the deterioration table determining section 12 determines the deterioration table, the charge and discharge schedule creating section 15 creates a charge and discharge schedule based on the demand prediction, the power generation prediction, and the deterioration table (step S15). When the charge and discharge schedule creating section 15 creates the charge and discharge schedule, the first communication section 16 transmits the demand prediction, the power generation prediction, the deterioration table, and the charge and discharge schedule to the deterioration amount control apparatus 20 (step S16).

When the first communication section 16 transmits the data to the deterioration amount control apparatus 20, the deterioration amount monitoring apparatus 10 ends the operation.

Intervals at which the deterioration amount control apparatus 20 transmits the data to the deterioration amount monitoring apparatus 10 are half days and full days but are not limited to a particular period.

Now, an operation example of the deterioration amount control apparatus 20 will be described.

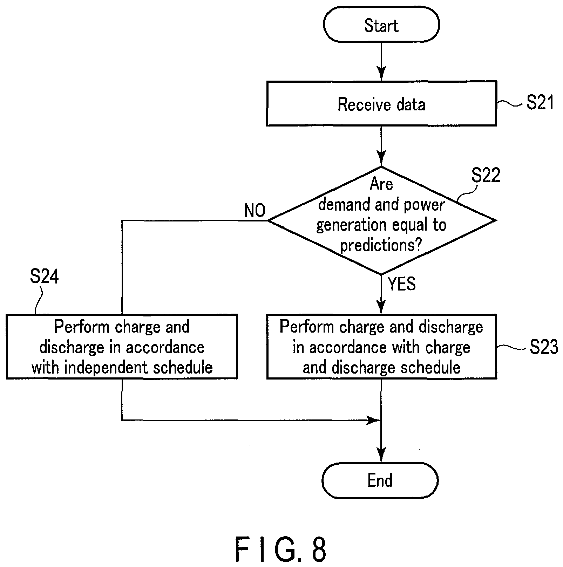

FIG. 8 is a flowchart illustrating an operation example of the deterioration amount control apparatus 20.

First, the second communication section 23 of the deterioration amount control apparatus 20 receives the demand prediction, the power generation prediction, the deterioration table, and the charge and discharge schedule from the deterioration amount monitoring apparatus 10 (step S21).

When the second communication section 23 receives the data, the determination section 22a determines, with reference to the demand prediction and the power generation prediction, whether the actual demand and power generation are equal to the demand prediction and the power generation prediction, respectively (step S22). A method is as described above in which the determination section 22a determines whether the actual demand and power generation are equal to the demand prediction and the power generation prediction, respectively.

When the determination section 22a determines that the actual demand and power generation are equal to the demand prediction and the power generation prediction, respectively (step S22, YES), the first control section 22b controls the charge and discharge of the battery 53 in accordance with the received charge and discharge schedule (step S23). That is, the first control section 22b transmits a control signal based on the received charge and discharge schedule to the PCS 54. The PCS 54 charges and discharges the battery 53 in accordance with the control signal transmitted by the first control section 22b.

When the determination section 22a determines that the actual demand and power generation are not equal to the demand prediction and the power generation prediction, respectively (step S22, NO), the second control section 22c creates an independent schedule based on the deterioration table and controls the charge and discharge of the battery 53 in accordance with the created independent schedule (step S24). That is, the second control section 22c transmits the control signal based on the independent schedule.

When the first control section 22b controls the charge and discharge of the battery 53 in accordance with the charge and discharge schedule (step S23) or when the second control section 22c controls the charge and discharge of the battery 53 in accordance with the independent schedule (step S24), the deterioration amount control apparatus 20 ends the operation.

The deterioration amount control apparatus 20 may repeatedly perform the operations in step S22 and the subsequent steps at predetermined intervals. For example, the deterioration amount control apparatus 20 may repeat step S22 and the subsequent steps at hourly intervals. Furthermore, the deterioration amount control apparatus 20 may control the battery 53 in accordance with the independent schedule after creating the schedule and before receiving a new charge and discharge schedule. Furthermore, when the actual demand and power generation are equal to the demand prediction and the power generation prediction, respectively, the deterioration amount control apparatus 20 may control the battery 53 in accordance with the received charge and discharge schedule.

Furthermore, the battery condition measuring section 21 collects the battery condition information on the battery 53. Upon collecting the battery condition information, the battery condition measuring section 21 transmits the battery condition information on the battery 53 to the deterioration amount monitoring apparatus 10 at predetermined intervals. For example, the second communication section 23 transmits the battery condition information on the battery 53 to the deterioration amount monitoring apparatus 10 at hourly or daily intervals. The timings when the second communication section 23 transmits the battery condition information on the battery 53 are not limited to a particular configuration.

In the deterioration amount control system configured as described above, even when the demand prediction and the power generation prediction are not equal to the actual demand and power generation, respectively, the deterioration amount control apparatus creates an independent schedule to allow the deterioration amount of the battery to be controlled.

### (Second Embodiment)

Now, a deterioration amount control system according to a second embodiment will be described.

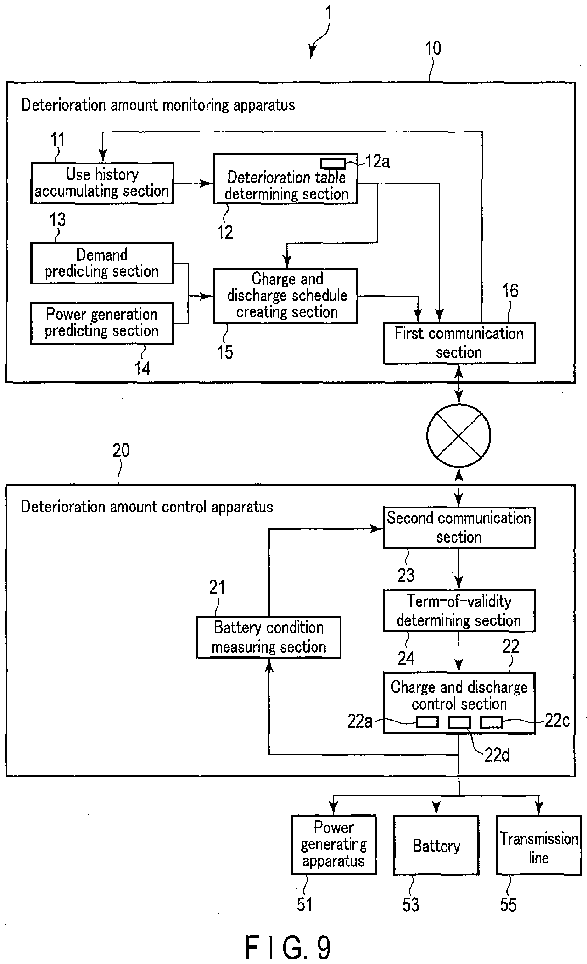

FIG. 9 is a block diagram depicting a function example of a deterioration amount control system 1 according to the second embodiment.

The function example of the deterioration amount control system 1 according to the second embodiment is different from the function example of the deterioration amount control system 1 according to the first embodiment in that the deterioration table determining section 12 comprises a term-of-validity setting section 12a and in that the deterioration amount control apparatus 20 comprises a term-of-validity determining section 24. Therefore, the remaining part of the configuration is represented using the same reference numerals and will not be described in detail.

The term-of-validity setting section 12a provided in the deterioration table determining section 12 sets a term of validity in the deterioration table determined by the deterioration table determining section 12. The term of validity indicates a period during which the deterioration table is available. The term of validity may be a date and time or a time after the transmission of the deterioration table.

For example, the term of validity is a period when the internal state of the battery 53 is locally stable. Furthermore, the term of validity is the period when the deterioration rate of the battery 53 remains the same or when the deterioration rate is approximately the same.

The term-of-validity setting section 12a determines the term of validity based on the type, use history, temperature of the battery 53 and a heating time during a manufacturing process for the battery 53. For example, the term-of-validity setting section 12a may determine the term of validity by applying the data to a preset model.

For example, when the duration of use of the battery 53 is relatively short, the deterioration rate of the battery 53 is unstable. Thus, when the duration of use of the battery 53 is relatively short, the term-of-validity setting section 12a determines the term of validity to be a relatively short time. Furthermore, when the duration of use of the battery 53 is relatively long, the deterioration rate of the battery 53 is stable. Thus, when the duration of use of the battery 53 is relatively long, the term-of-validity setting section 12a determines the term of validity to be a relatively long time.

A method in which the term-of-validity setting section 12a determines the term of validity is not limited to a particular method.

The term-of-validity determining section 24 of the deterioration amount control apparatus 20 determines whether the current time is within the term of validity set in the deterioration table. When the current time is within the term of validity, the term-of-validity determining section 24 sets the deterioration table received from the deterioration amount monitoring apparatus 10 (server deterioration table) to be a deterioration table used to create an independent schedule. Furthermore, when the current time is not within the term of validity, the term-of-validity determining section 24 sets the deterioration table pre-stored in the deterioration amount control apparatus 20 (local deterioration table) to be a deterioration table used to create an independent schedule.

The local deterioration table is stored in the term-of-validity determining section 24, for example, during a stage of manufacture of the deterioration amount control apparatus 20.

The local deterioration table may indicate steady deterioration of the battery 53. The steady deterioration is a deterioration phenomenon excluding a temporary increase or decrease in capacity generally observed during an early phase of use and corresponding to stable deterioration observed from the middle to end of the life of the battery 53. The local deterioration table is not limited to particular contents.

Now, a configuration example of the deterioration amount control system 1 according to the second embodiment will be described.

The configuration example of the deterioration amount control system 1 according to the second embodiment is different from the configuration example of the deterioration amount control system 1 according to the first embodiment in that the NVM 44 comprises a recording area 44c (see FIG. 5) in which the local deterioration table is stored. Therefore, the remaining part of the configuration will not be described.

The local deterioration table is stored in the recording area 44c stored in the NVM 44. As described above, the local deterioration table is pre-stored in the recording area 44c, for example, at the time of manufacture of the deterioration amount control apparatus 20.

Now, an operation example of the deterioration amount monitoring apparatus 10 will be described.

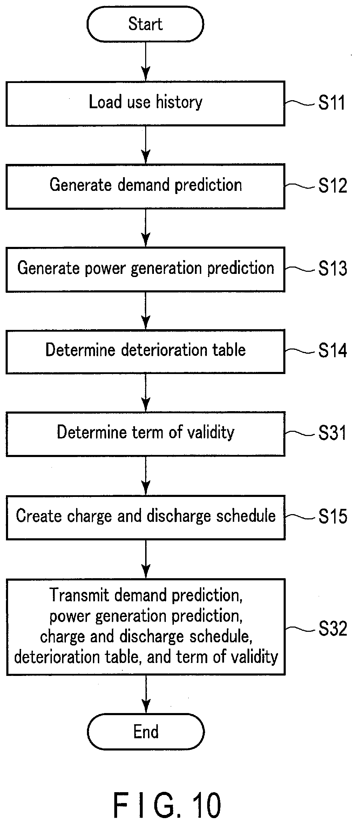

FIG. 10 is a flowchart illustrating the operation example of the deterioration amount monitoring apparatus 10.

Operations in steps S11 to S14 are the same as the operations of the deterioration amount monitoring apparatus 10 in the first embodiment and will thus not be described below.

When the deterioration table determining section 12 determines a deterioration table, the term-of-validity setting section 12a sets the term of validity in the determined deterioration table (step S31). When the term-of-validity setting section 12a sets the term of validity in the deterioration table, the charge and discharge schedule creating section 15 creates a charge and discharge schedule (step S15).

When the charge and discharge schedule creating section 15 creates the charge and discharge schedule, the first communication section 16 transmits a demand prediction, a power generation prediction, a charge and discharge schedule, the deterioration table, and the term of validity to the deterioration amount control apparatus 20 (step S32). When the first communication section 16 transmits the data to the deterioration amount control apparatus 20, the deterioration amount monitoring apparatus 10 ends the operation.

Now, an operation example of the deterioration amount control apparatus 20 will be described.

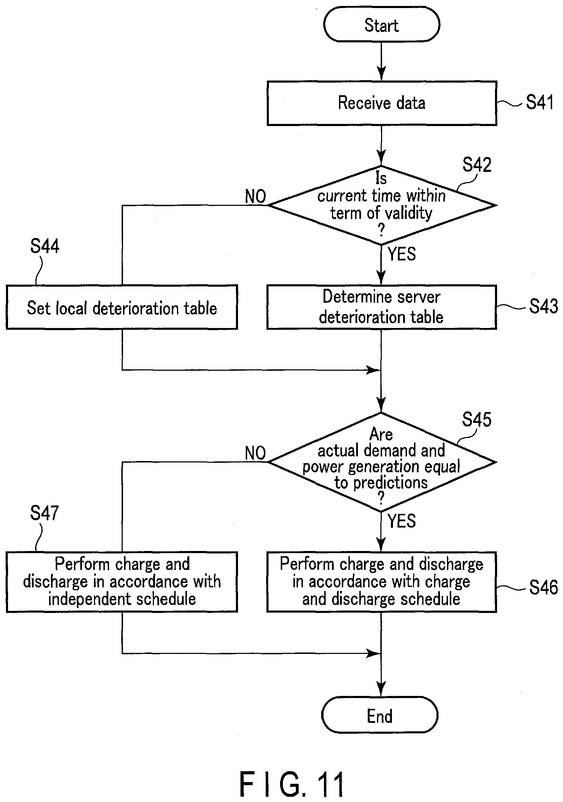

FIG. 11 is a flowchart illustrating the operation example of the deterioration amount control apparatus 20.

First, the second communication section 23 of the deterioration amount control apparatus 20 receives the demand prediction, the power generation prediction, the charge and discharge schedule, the deterioration table (server deterioration table), and the term of validity from the deterioration amount monitoring apparatus 10 (step S41).

When the second communication section 23 receives the data, the term-of-validity determining section 24 determines whether the current time is within the term of validity (step S42). Upon determining that the current time is within the term of validity (step S42, YES), the term-of-validity determining section 24 sets the server deterioration table to be a deterioration table used to create an independent schedule (step S43).

Upon determining that the current time is within the term of validity (step S42, NO), the term-of-validity determining section 24 sets the local deterioration table to be a deterioration table used to create an independent schedule (step S44).

When the term-of-validity determining section 24 sets the server deterioration table (step S43) or when the term-of-validity determining section 24 sets the local deterioration table (step S44), the determination section 22a determines with reference to the demand prediction and the power generation prediction whether the demand prediction and the power generation prediction are equal to the actual demand and power generation (step S45).

When the determination section 22a determines that the demand prediction and the power generation prediction are equal to the actual demand and power generation (step S45, YES), the first control section 22b controls the charge and discharge of the battery 53 in accordance with the charge and discharge schedule (step S46).

When the determination section 22a determines that the demand prediction and the power generation prediction are not equal to the actual demand and power generation (step S45, NO), the second control section 22c creates an independent schedule based on the deterioration table (server deterioration table or local deterioration table) set to allow the independent schedule to be created, and controls the charge and discharge of the battery 53 in accordance with the created independent schedule (step S47). That is, when the current time is within the term of validity, the second control section 22c creates an independent schedule based on the server deterioration table and controls the charge and discharge of the battery 53 in accordance with the created independent schedule. Furthermore, when the current time is not within the term of validity, the second control section 22c creates an independent schedule based on the local deterioration table and controls the charge and discharge of the battery 53 in accordance with the created independent schedule.

When the first control section 22b controls the charge and discharge of the battery 53 in accordance with the charge and discharge schedule (step S46) or when the second control section 22c controls the charge and discharge of the battery 53 in accordance with the independent schedule (step S47), the deterioration amount control apparatus 20 ends the operation.

The deterioration amount control apparatus 20 may repeatedly perform the operations in step S42 and the subsequent steps at predetermined intervals. For example, the deterioration amount control apparatus 20 may repeat step S42 and the subsequent steps at hourly intervals.

If the period has passed when the deterioration table allows the deterioration rate to be properly indicated, the deterioration amount control system configured as described above enables the deterioration of the battery to be controlled using the independent deterioration table. As a result, the deterioration amount control system enables the deterioration of the battery to be controlled even when the communication between the deterioration amount monitoring apparatus and the deterioration amount control apparatus is disrupted.

### (Third Embodiment)

Now, a deterioration amount control system according to a third embodiment will be described.

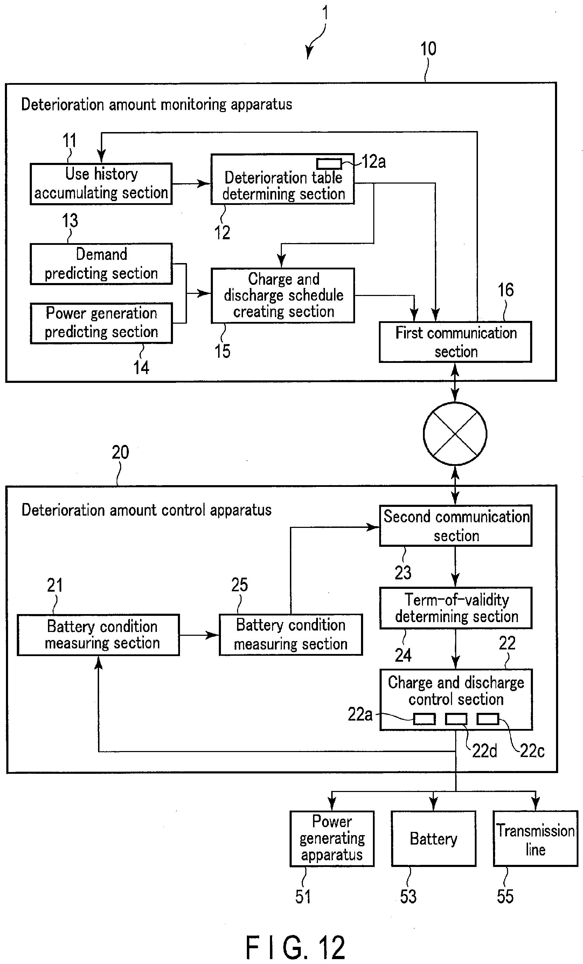

FIG. 12 is a block diagram depicting a function example of a deterioration amount control system 1 according to the third embodiment.

The function example of the deterioration amount control system 1 according to the third embodiment is different from the function example of the deterioration amount control system 1 according to the second embodiment in that the deterioration amount control apparatus 20 comprises a battery condition recording section 25. Therefore, the remaining part of the configuration is represented using the same reference numerals and will not be described in detail.

The battery condition recording section 25 stores the battery condition information generated by the battery condition measuring section 21 when communication with the deterioration amount monitoring apparatus 10 is disrupted. The battery condition recording section 25 continues to additionally store the battery condition information generated by the battery condition measuring section 21.

When the communication with the deterioration amount monitoring apparatus 10 is recovered, the second communication section 23 transmits the battery condition information stored in the battery condition recording section 25 to the deterioration amount monitoring apparatus 10.

When the communication with the deterioration amount monitoring apparatus 10 is recovered, the battery condition recording section 25 may calculate, for example, average values for the stored items of the battery condition information. In this case, the second communication section 23 may transmit the average values and the like calculated by the battery condition recording section 25 to the deterioration amount monitoring apparatus 10.

The term-of-validity determining section 24 further determines, after the recovery of the communication with the deterioration amount monitoring apparatus 10, whether a deterioration table received from the deterioration amount monitoring apparatus 10 is the latest. That is, the term-of-validity determining section 24 determines whether the received deterioration table is a deterioration table determined based on a use history corresponding to the period of the disruption of the communication based on the date and time of the determination of the deterioration table from the deterioration amount monitoring apparatus 10.

Now, a configuration example of the deterioration amount control system 1 according to the third embodiment will be described.

The configuration example of the deterioration amount control system 1 according to the third embodiment is different from the configuration example of the deterioration amount control system 1 according to the first embodiment in that the NVM 44 comprises a recording area 44d (see FIG. 5) in which the use history is stored. Therefore, the remaining part of the configuration will not be described.

The battery condition information on the battery 53 is stored in the recording area 44d provided in the NVM 44 when the communication with the deterioration amount monitoring apparatus 10 is disrupted. As described above, while the communication with the deterioration amount monitoring apparatus 10 is disrupted, the battery condition information continues to be additionally stored in the recording area 44d.

Now, an example of operations of the deterioration amount control apparatus 20 performed when the communication with the deterioration amount monitoring apparatus 10 is disrupted will be described.

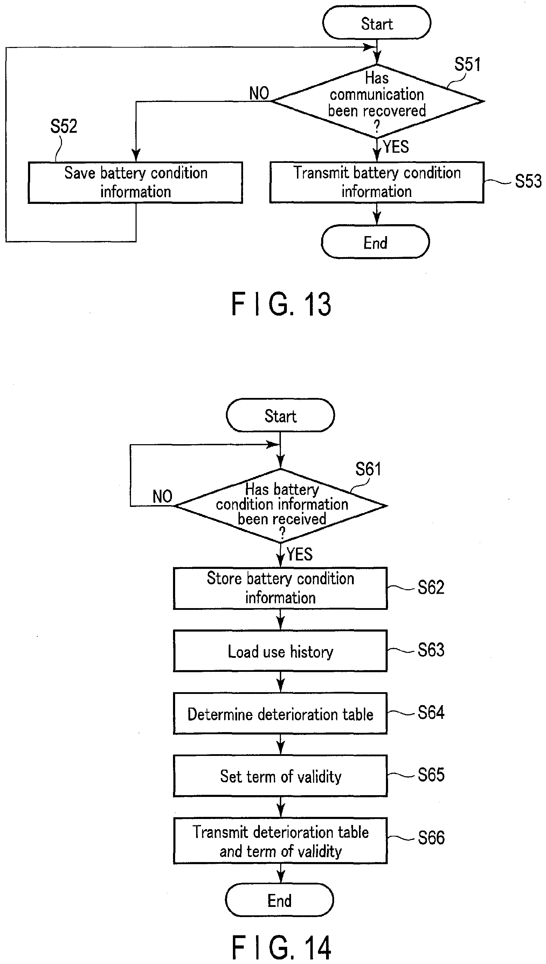

FIG. 13 is a flowchart illustrating the example of operations of the deterioration amount control apparatus 20 performed when the communication with the deterioration amount monitoring apparatus 10 is disrupted.

First, the deterioration amount control apparatus 20 determines whether the communication with the deterioration amount monitoring apparatus 10 has been recovered (step S51).

When the deterioration amount control apparatus 20 determines that the communication with the deterioration amount monitoring apparatus 10 has not been recovered (step S51, NO), the battery condition recording section 25 stores the battery condition information generated by the battery condition measuring section 21 (step S52).

When the deterioration amount control apparatus 20 determines that the communication with the deterioration amount monitoring apparatus 10 has been recovered (step S51, YES), the second communication section 23 transmits the battery condition information stored in the battery condition recording section 25 to the deterioration amount monitoring apparatus 10 (step S53). When the second communication section 23 transmits the battery condition information to the deterioration amount monitoring apparatus 10, the deterioration amount control apparatus 20 ends the operation.

Now, an example of operations of the deterioration amount monitoring apparatus 10 performed when the communication with the deterioration amount control apparatus 20 is recovered.

FIG. 14 is a flowchart illustrating the example of operations of the deterioration amount monitoring apparatus 10 performed when the communication with the deterioration amount control apparatus 20 is recovered.

First, the first communication section 16 of the deterioration amount monitoring apparatus 10 determines whether the battery condition information has been received from the deterioration amount control apparatus 20 (step S61). When the first communication section 16 of the deterioration amount monitoring apparatus 10 determines that the battery condition information has not been received from the deterioration amount control apparatus 20 (step S61, NO), the deterioration amount monitoring apparatus 10 returns to step S61.

When the first communication section 16 receives the battery condition information from the deterioration amount control apparatus 20 (step S61, YES), the use history accumulating section 11 stores the battery condition information in accordance with the time series as a use history (step S62).

When the use history accumulating section 11 stores the battery condition information, the deterioration table determining section 12 loads the use history (step S63). Upon loading the use history, the deterioration table determining section 12 determines a deterioration table (step S64).

When the deterioration table determining section 12 determines the deterioration table, the term-of-validity setting section 12a sets a term of validity in the deterioration table determined by the deterioration table determining section 12 (step S65).

When the term-of-validity setting section 12a sets the term of validity, the first communication section 16 transmits the deterioration table and the term of validity to the deterioration amount control apparatus 20 (step S66). When the first communication section 16 transmits the deterioration table and the term of validity to the deterioration amount control apparatus 20, the deterioration amount control apparatus 20 ends the operation.

Now, an operation example in which the deterioration amount control apparatus 20 updates the deterioration table will be described.

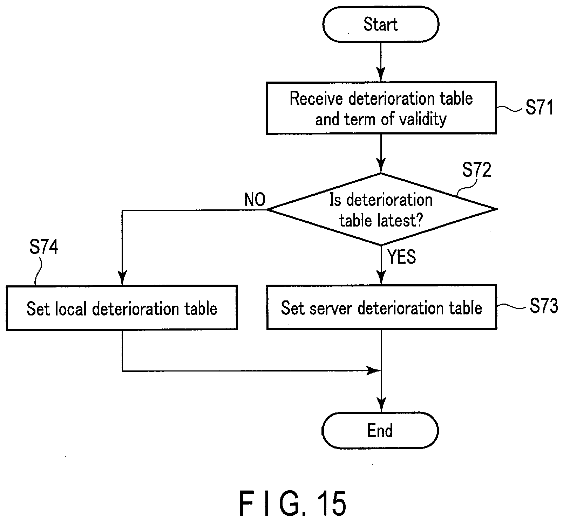

FIG. 15 is a flowchart illustrating the operation example in which the deterioration amount control apparatus 20 updates the deterioration table.

First, the second communication section 23 of the deterioration amount control apparatus 20 receives the deterioration table (server deterioration table) and the term of validity from the deterioration amount monitoring apparatus 10 (step S71).

When the second communication section 23 receives the data, the term-of-validity determining section 24 determines whether the server deterioration table is the latest (step S72). Upon determining that the server deterioration table is the latest (step S72, YES), the term-of-validity determining section 24 sets the server deterioration table to be a deterioration table used to create an independent schedule (step S73).

Upon determining that the server deterioration table is not the latest (step S72, NO), the term-of-validity determining section 24 sets the local deterioration table to be a deterioration table used to create an independent schedule (step S74).

When the term-of-validity determining section 24 sets the server deterioration table (step S73) or when the term-of-validity determining section 24 sets the local deterioration table (step S74), the deterioration amount control apparatus 20 ends the operation.

Upon determining that server deterioration table is not the latest, the deterioration amount control apparatus 20 may wait until the deterioration amount monitoring apparatus 10 transmits the deterioration table.

The deterioration amount control system configured as described above enables the deterioration table for the deterioration amount control apparatus to be updated when the communication between the deterioration amount monitoring apparatus and the deterioration amount control apparatus is recovered. As a result, the deterioration amount control system increases the accuracy of deterioration control.

Several embodiments of the present invention have been described. However, the embodiments have been presented as examples and are not intended to limit the scope of the invention. These novel embodiments can be implemented in various other forms. Various omissions, replacements, and changes may be made to the embodiments without departing from the spirit of the invention. The embodiments and variations thereof are included in the scope and spirit of the invention and also in the invention recited in the claims and equivalents thereof.

### Reference Signs List

1 Deterioration amount control system (control system)
10 Deterioration amount monitoring apparatus
11 Use history accumulating section
12 Deterioration table determining section
12a Term-of-validity setting section
13 Demand predicting section
14 Power generation predicting section
15 Charge and discharge schedule creating section
16 First communication section
20 Deterioration amount control apparatus (control apparatus)
21 Battery condition measuring section
22 Charge and discharge control section
22a Determination section
22b First control section
22c Second control section
23 Second communication section
24 Term-of-validity determining section
25 Battery condition recording section
51 power generating apparatus
53 Battery
55 Transmission line

## Claims

1. A monitoring apparatus comprising:
a use history accumulating section configured to receive at least battery condition information from a control apparatus that controls a power generating apparatus and a battery and to generate and to store a use history of the battery;
a demand prediction generating section configured to generate a demand prediction for power consumed by a power consuming section for which power supply is controlled by the control apparatus;
a power generation predicting section configured to generate a power generation prediction for the power generating apparatus;
a deterioration table determining section configured to determine a deterioration table indicative of a deterioration rate of the battery based on the use history;
a charge and discharge schedule creating section configured to create a charge and discharge schedule for the battery based on the deterioration table, the demand prediction, and the power generation prediction; and
a transmission section configured to transmit the demand prediction, the power generation prediction, the charge and discharge schedule, and the deterioration table allowing charge and discharge of the battery to be controlled.

2. The monitoring apparatus according to claim 1, further comprising:
a term-of-validity setting section configured to set a term of validity to the deterioration table, wherein
the transmission section further transmits the term of validity to the control apparatus.

3. The monitoring apparatus according to claim 1 or 2, wherein the use history accumulating section receives battery condition information corresponding to a period when the communication is disrupted from the control apparatus, when communication with the control apparatus is disrupted and then recovered, and generates and stores the use history based on the battery condition information,
the deterioration table determining section determines the deterioration table based on the use history, and
the transmission section transmits the deterioration table to the control apparatus.

4. The monitoring apparatus according to any one of claims 1 to 3, wherein the deterioration table is indicative of the deterioration rate corresponding to a temperature and an SOC of the battery.

5. The monitoring apparatus according to any one of claims 1 to 4, wherein the deterioration table represents the deterioration rate as a binary value.

6. A control apparatus configured to control a battery, a power generating apparatus, and a power consuming section, the control apparatus comprising:
a battery measuring section configured to generate battery condition information on the battery;
a transmission section configured to transmit the battery condition information to a monitoring apparatus;
a reception section configured to receive a demand prediction, a power generation prediction, a deterioration table, and a charge and discharge schedule from the monitoring apparatus;
a determination section configured to determine whether the demand prediction and the power generation prediction are equal to a power demand of the power consuming section and an amount of power generated by the power generating apparatus, respectively;
a first control section configured to control charge and discharge of the battery in accordance with the charge and discharge schedule when the determination section determines that the demand prediction and the power generation prediction are equal to the power demand of the power consuming section and the amount of power generated by the power generating apparatus, respectively; and
a second control section configured to control the charge and discharge of the battery based on the deterioration table when the determination section determines that the demand prediction and the power generation prediction are not equal to the power demand of the power consuming section and the amount of power generated by the power generating apparatus, respectively.

7. The control apparatus according to claim 6, wherein the reception section receives a term of validity set to the deterioration table,
the control apparatus further comprises:
a first recording section configured to pre-store a local deterioration table; and
a term-of-validity determining section configured to determine whether the term of validity includes a current time, wherein
the second control section controls the charge and discharge of the battery based on the deterioration table when the term-of-validity determining section determines that the term of validity includes the current time and controls the charge and discharge of the battery based on the local deterioration table when the term-of-validity determining section determines that the term of validity does not include the current time.

8. The control apparatus according to claim 7, further comprising:
a second recording section configured to store battery condition information generated by the battery condition measuring section when communication with the monitoring apparatus is disrupted, wherein
the transmission section transmits the battery condition information to the monitoring apparatus when the communication with the monitoring apparatus is recovered.

9. The control apparatus according to any one of claims 6 to 8, wherein the deterioration table is indicative of the deterioration rate corresponding to a temperature and an SOC of the battery.

10. The monitoring apparatus according to any one of claims 6 to 9, wherein the deterioration table represents the deterioration rate as a binary value.

11. A control system having a monitoring apparatus and a control apparatus, the system comprising:
a use history accumulating section configured to receive at least battery condition information from the control apparatus that controls a power generating apparatus and a battery and to generate and to store a use history of the battery;
a demand prediction generating section configured to generate a demand prediction for power consumed by a power consuming section for which power supply is controlled by the control apparatus;
a power generation predicting section configured to generate a power generation prediction for the power generating apparatus;
a deterioration table determining section configured to determine a deterioration table indicative of a deterioration rate of the battery based on the use history;
a charge and discharge schedule creating section configured to create a charge and discharge schedule for the battery based on the deterioration table, the demand prediction, and the power generation prediction; and
a first transmission section configured to transmit the demand prediction, the power generation prediction, the charge and discharge schedule, and the deterioration table allowing charge and discharge of the battery to be controlled, and
the control apparatus comprises:
a battery measuring section configured to generate battery condition information on the battery;
a second transmission section configured to transmit the battery condition information to the monitoring apparatus;
a reception section configured to receive the demand prediction, the power generation prediction, the deterioration table, and the charge and discharge schedule from the monitoring apparatus;
a determination section configured to determine whether the demand prediction and the power generation prediction are equal to a power demand of the power consuming section and an amount of power generated by the power generating apparatus, respectively;
a first control section configured to control charge and discharge of the battery in accordance with the charge and discharge schedule when the determination section determines that the demand prediction and the power generation prediction are equal to the power demand of the power consuming section and the amount of power generated by power generating apparatus, respectively; and
a second control section configured to control the charge and discharge of the battery based on the deterioration table when the determination section determines that the demand prediction and the power generation prediction are not equal to the power demand of the power consuming section and the amount of power generated by the power generating apparatus, respectively.
